Europäisches Patentamt

(19) European Patent Office

Office européen des brevets

(11) Publication number: **0 436 588 B1**

(12) **EUROPEAN PATENT SPECIFICATION**

(45) Date of publication of patent specification: **23.03.94** (51) Int. Cl.⁵: **H01L 21/31**

(21) Application number: **89910613.2**

(22) Date of filing: **18.09.89**

(86) International application number:
**PCT/EP89/01083**

(87) International publication number:
**WO 90/03660 (05.04.90 90/08)**

(54) **LOW STRESS POLYSILICON MICROSTRUCTURES.**

(30) Priority: **28.09.88 US 250055**

(43) Date of publication of application:
**17.07.91 Bulletin 91/29**

(45) Publication of the grant of the patent:
**23.03.94 Bulletin 94/12**

(84) Designated Contracting States:
**DE FR GB IT**

(56) References cited:
**WO-A-86/06877**

**APPLIED PHYSICS A. SOLIDS AND SUR-FACES, vol. A40, no. 2, June 1986, Springer-Verlag (Berlin, DE) ; R.A. COLLINS et al. : "Tantalum and cobalt silicides : temperature sensor applications", pages 409-417.**

**EXTENDED ABSTRACTS OF THE 19TH CON-FERENCE ON SOLID STATE DEVICES AND MATERIALS, 1987, J.S.A.P. (JP) ; K. SUGURO et al. : "Impurity effect on reduction in ther-mal stress of titanium silicides", pages**

423-426.

**THIN SOLID FILMS, vol. 140, no. 1, 16 June 1986, Elsevier Sequoia (Lausanne, CH) ; S.P. MURARKA : "Codeposited silicides in very-large-scale integration", pages 35-50.**

(73) Proprietor: **SIEMENS AKTIENGESELLSCHAFT**
**Wittelsbacherplatz 2**
**D-80333 München(DE)**

(72) Inventor: **WILCOXEN, Duane, T.**
**1105 Dangelion**
**Garland, Texas 75043(US)**

## Description

## FIELD OF THE INVENTION

The present invention relates to a method for relieving stress in silicon microstructures by the use of silicides and to microstructures comprising low stress silicon.

## BACKGROUND OF THE INVENTION

In recent years, there has been a rapid growth in the application of silicon-based electronics systems, especially for automotive applications. The silicon-based electronics are used to store control algorithms, process information, and to direct actuators to perform various functions, including steering, suspension, and display of driver information, to name but a few. While the electronics revolution unfolds, sensor technology, on the other hand, is lagging behind, and sensor designs continue to be based on dated technologies with associated limitations. Recent trends have identified silicon as a material well suited for future sensor technology which hopefully will close this technology gap and permit greater application of control systems utilizing sensor technology.

Existing control systems use silicon-based electronics, and nearly all have embedded microprocessors. Silicon is widely recognized in the industry as being suitable for this application in view of its high reliability, high strength and low cost. In addition, silicon sensor designs can be created using a variety of manufacturing processes one of the most promising of which is referred to as "micromachining" which uses chemical processes to introduce three-dimensional mechnical structures in silicon. These "microstructures", as they are called, can be made sensitive to specific physical phenomena, such as acceleration, gas flow rate or pressure, by taking advantage of the special piezo resistive properties of silicon. For example, a micromachined cantilivered beam produces a minute resistance change when flexed by the force of acceleration. However, the output signal from this micromachined sensor is very small (millivolts), so that additional electronic circuitry is necessary for signal conditioning and amplification. These electronic circuits are usually integrated circuit chips which are interconnected to the micromachined element. Different aspects of micromachining are reviewed in Lee et al, "Silicon Micromachining Technology for Automotive Applications", SAE Publication No. SP655, February 1986, and the content of that publication is hereby incorporated by reference.

A disadvantage associated with polycrystalline silicon is that it is known to have an inherent high compressive stress. For example, undoped crystalline polysilicon has a stress of the order of -5 x $10^9$ dyne/cm$^2$ (1 dyne = $10^{-5}$ N). This high compressive stress is disadvantageous especially when polysilicon is used for the fabrication of free-standing microstructures, such as cantilivers or bridges, which must be mechanically stable and not buckle or break. Such structures must have a low level of stress in order to facilitate the formation of free-standing structures of sufficient dimension to be useful as sensing elements. In a typical polysilicon deposition process used widely in the fabrication of integrated circuits today, silane gas is injected into a process tube at low pressure and a temperature of approximately 625°C. These processing conditions produce a very uniform layer of deposited polysilicon material on a substrate. However, thermal coefficient of expansion differences of the polysilicon layer and the underlying material will produce a net compressive force in the polysilicon and this gives rise to the disadvantages noted earlier.

Recently, there has been much research into methods for producing stress-free polysilicon. These methods have primarily been to deposit the silicon at a temperature that will produce an amorphous silicon film having little or no crystalline structure present. There have been other attempts to anneal the polysilicon in different ways to relieve the stress. All of the prior methods suffer from the disadvantage that they change the polysilicon deposition parameters and utilize high temperatures (i.e. above 600°C), and so are incompatible with current technology trends and processing methods. In particular, the use of high temperatures for annealing and other processing is precluded because of the potential heat damage to the electronic components.

## SUMMARY OF THE INVENTION

It has now been found, according to the present invention, that it is possible to achieve satisfactory stress relief in micromachined structures using low temperature technology (i.e. at 500°C and lower) which is very advantageous in the production of integrated sensor structures. The methodology of the present invention has little or no effect on the processing parameters of the polysilicon deposition, thereby making the methodology more compatible with current processing methods.

The underlying concept of the present invention is to utilize a stress modifying material to form a modified stress-relieved microstructure, in which the total stress level of the resulting microstructure is modified. This stress modifying material should have a stress force which is in the opposite direction (i.e. have an opposite sign) to that of the microstructure material, so that the stress level in the stress-modifying material and the microstructure material essentially cancel each other out and produce a resultant overall low stress level for the resulting microstructure. It has been found, according to the present invention, that silicides have this property and can be formed at low temperatures of 500°C or lower on the surface of the microstructure material to reduce the overall stress of the microstructure.

Thus, according to the present invention, there is provided a method as claimed in claim 1 It has been found that silicidation is effective to relieve inherent stress present in polysilicon micromachined structures. Particularly good results have been obtained by forming a layer of platinum silicide on such polysilicon microstructures.

The silicide is formed by bringing platinum into contact with polysilicon, and sintering at high temperature not higher than 500°C to form the silicide.

Different overall stress levels are produced in the microstructure by different thicknesses of silicide on the microstructure. Thus, by choosing appropriate thicknesses of the silicide layer it is possible, according the present invention, to fabricate free-standing microstructures, such as bridges and cantilivers, having dimensions which are large enough to be useful as a sensing element, while having a sufficiently low level of tensile stress that they do not buckle or collapse, and therefore effectively function as a sensor element.

The stress of the resulting combined free-standing microstructures is typically not more than $10 \times 10^9$ dyne/cm$^2$. More usually, the stress is in the region of $10 \times 10^7$ to $15 \times 10^8$ dyne/cm$^2$, preferably $8 \times 10^8$ to $10 \times 10^8$ dyne/cm$^2$. Examples of typical sensors which can be fabricated according to the present invention are mass air flow sensors (MAFS), accelerometers, and pressure sensors. However, it will be understood that the invention is not limited to the type of sensor, and can be used to relieve inherent stress in microstructures employed in any device or situation.

## BRIEF DESCRIPTION OF THE DRAWINGS

The invention will now be further described with reference to the accompanying drawings, in which:

Figures 1 through 8 illustrate schematically the formation of a low stress microstructure according to the method of the invention;

Figure 9 shows a diaphragm structure formed by back-etching techniques; and

Figure 10 shows an integrated silicon sensor having an integrated circuit and a low-stress top side microstructure.

## DETAILED DESCRIPTION OF THE INVENTION

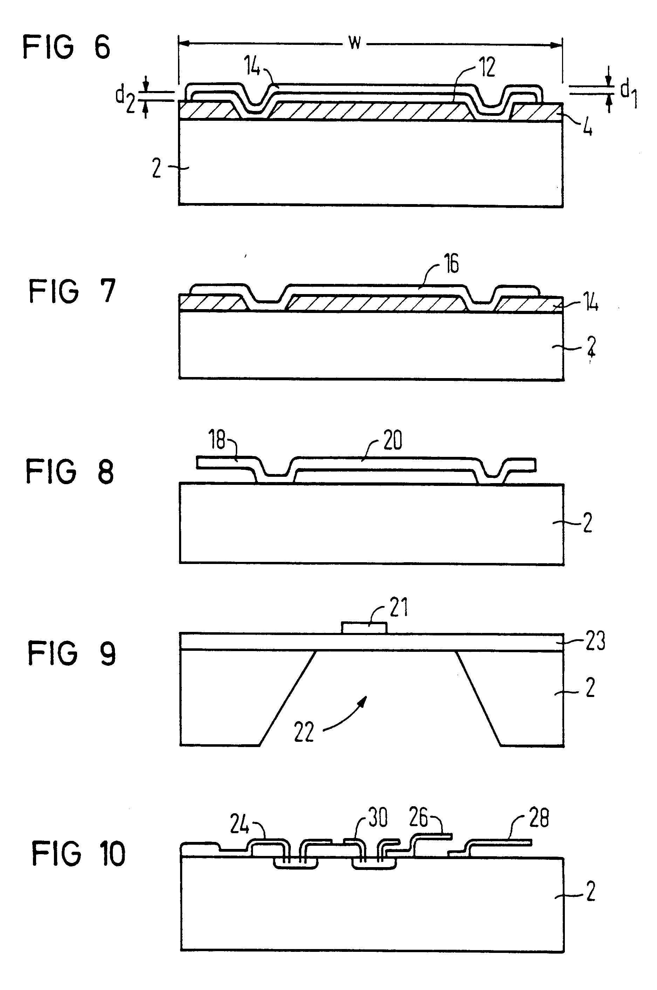

Before discussing the invention in detail, it will he understood that, for the purposes of simplicity and ease of description and understanding, the invention will now be discussed with respect to the formation of a microstructure of an uncomplicated type on one side (the "top side") of a semiconductor substrate. It will be appreciated, however, that in a typical arrangement, there may be one or more integrated circuit components and one or more microstructures formed on the top side of the silicon substrate. It will also be appreciated that the present invention is equally applicable to structures formed by etching from the back side of the substrate such as is illustrated in Figure 9.

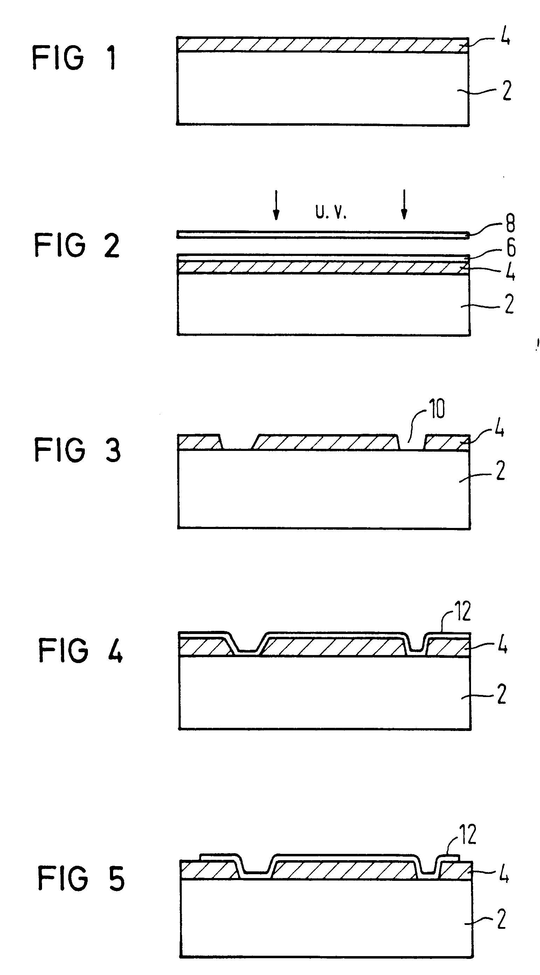

Referring to Figures 1 through 8, there is shown a silicon substrate 2, typically in the form of a wafer, on which has been formed a silicon dioxide layer 4. The oxide layer (or sacrificial layer) 4 is formed by oxidising the silicon substrate 2 at a temperature between 950 to 1100°C, typically a 1000 to 1050°C for a period of about 3 to 6 hours, typically about 4 hours in the presence of steam. The process in which the silicon layer is formed is conventional, and well known to a person of ordinary skill in this art. The resulting silicon oxide layer is typically about 1 to 2 micrometers thick.

The oxide layer 4 is then etched using conventional photolithography techniques to produce an etched oxide layer. In this step, the oxide layer on the silicon wafer is coated with an emulsion 6 of a standard photoresist material and subjected to ultraviolet light through a mask 8 to define the desired pattern in the emulsion layer, as shown in Figure 2.

The configuration shown in Figure 3 is produced by developing the exposed photoresist material according to conventional methodology. The etched layer 4 has windows 10 extending through to the silicon substrate.

Polysilicon is then deposited at a temperature of between 580° to 700°C, preferably about 625°C to form the structure shown in Figure 4. The polysilicon is deposited using conventional technology in which pure silane is applied to the oxide layer 4 using low pressure chemical vapor deposition (LPCVD) at a pressure of about 200 to 400 mTorr (1 Torr = 0.133 kPa), preferably at about 300 mTorr, over a period of 45 to 60 minutes, preferably for about 50 minutes. The thickness of the resulting polysilicon layer can range from 200 to 1000 nm, and as typically in the region of 500 nm.

The polysilicon layer 12 is then etched to produce the structure shown in Figure 5. If desired, it is possible to oxidise the layer 12 at about 850 to 1200°C for 90 to 120 minutes to form an oxide layer which is then etched. Again, conventional etching techniques may be employed, such as, for example, reactive ion etching (RIE) using a mixture of carbon tetrachloride and oxygen at a pressure of about 80 to 100 mTorr for an etch time of about 10 to 20 minutes and at a power level of about 60 watts.

Figure 6 shows the result of depositing a layer of platinum 14 onto the etched polysilicon layer 12. Platinum deposition is carried out using conventional techniques, such as, for example, by sputtering a platinum target utilizing bombardment with argon. The sputtering is ordinarily carried out at a temperature from about room temperature to about 300°C., for example about 200 to 300°C, usually at about 250°C, at a pressure of 1,33 to 5,32 Pa (10 to 40 mTorr), preferably at about 20 mtorr, and at a voltage of about 250 to 300 volts, typically around 280 volts. The thickness of the resulting sputtered platinum layer may range from 50 to 1000 nm, and is typically in the region of 150 to 200 nm Angstroms. The amount of platinum deposited may be calculated as described later to give a layer of sufficient thickness to achieve the desired balancing of stress in the ultimate silicided structure.

The wafer is then subjected to annealing at a temperature of 500°C or less, typically at about 400°C, to form a platinum silicide layer 16 on top of the oxide layer 4 (see Figure 7). The silicidation is carried out in an inert atmosphere, typically an atmosphere of nitrogen, for a period of about 45 minutes to 2 hours, typically for about an hour.

The remaining platinum not consumed in the silicidation is then stripped from the resulting annealed structure. Stripping may be carried out using conventional techniques, and is typically effected using an aqua regia solution of 11 parts water, 9 parts hydrochloric acid and 1 part nitric acid.

The sacrificial oxide layer 4 under the silicide layer 16 on the top side of the silicon substrate 2 is then etched away using a conventional oxide etch, for example hydrofluoric acid. Finally, rinsing with water or isopropyl alcohol completes the preparation of the desired microstructure as shown in Figure 8 having the silicided polysilicon as a low-stress free-standing microstructure on the top side of the silicon substrate 2.

The method of the invention produces low stress microstructures which are free-standing, and do not collapse due to internal compressive forces. Figure 8 shows free-standing cantiliver portions 18 as well as the bridge portion 20, all of which have a stress level such that they do not collapse or upwardly buckle.

The silicided microstructures formed according to the method of the invention generally have a stress of not more than $10 \times 10^9$ dyne/cm$^2$, prefer-

ably not more than about $15 \times 10^8$ dyne/cm$^2$, preferably $10 \times 10^7$ to $10 \times 10^8$ dyne/cm$^2$. The stress of the microstructures formed according to the method of the present invention can be measured by techniques known to persons of ordinary skill in the art. In particular, the method described by Guckel et al, "A simple Technique for the Determination of Mechanical Strain in Thin Films with Application to Polysilicon", J. App. Phys.,1671, 1985 may be used. The stress is then calculated from the strain measurements by way of Young's Modulus using known mathematical techniques. An alternative method for measuring the stress is to use a stress guage, such as the one supplied by Ionic Systems Inc. under the model number 30122. Such a guage measures the average stress across the wafer or across a section of the wafer.

Figure 9 shows a diaphragm structure typically used for mass air flow sensor devices. The structure includes a low-stress heater/sensor microstructure element 21 silicided according to the present invention, and mounted on a diaphragm membrane 23, composede typically of oxide/nitride layers. The backside area 22 is formed by conventional backside etching techniques of the silicon layer 2. It is important to note that, irrespective of whether front side structures or structures formed by etching from the backside of the silicon substrate are involved, in both instances, the use of low temperature, (i.e. 500°C or less, for example 150 to 450°C, typically 300 to 400°C) facilitates the formation of low-stress microstructures, even in the presence of integrated circuit components on the wafer. The use of temperatures above 500°C in the formation microstructures gives rise to the serious risk of thermal damage to the integrated circuit components on the wafer.

A further advantage associated wih the formation of top side structures is that all the processing can be effected from one side of the wafer. In the embodiment shown in Figure 9, sophisticated apparatus must be used to facilitate handling of the wafer while processing is carried out on both the frontside and the backside of the wafer.

The above advantages are particularly well illustrated in Figure 10 which shows an integrated silicon sensor arrangement. The sensor includes integrated circuit components 24 on the left of the top side of the substrate 2, and microstructure components 26 on the right hand side of the top side. Silicidation of the microstructure facilitates the formation of low stress architecture which enables the cantiliver structure 28 and the bridge structure 30 to remain free-standing, and not to buckle or collapse due to internal compressive forces.

While not being bound to any theory, the following analysis is believed to facilitate an understanding of why the method of the present invention results in the formation of low stress microstructures. The following analysis is with reference to polycrystalline silicon silicided with platinum silicide, and makes the broad assumption that the stress forces of the silicide material and the polycrystalline silicon are in opposite directions (i.e. of opposite sign) and at the levels published in the literature. Based on those assumptions, the amount of platinum and of platinum silicide for a certain amount of polysilicon can be determined. This is illustrated below.

First, it will be assumed that the stress in the final structure is in the vertical plane only, and that the stress forces in each portion of the composite material are of the form:

$$stress = F/d.W = \sigma$$

wherein F is the force due to the stress field, d is the thickness of the film and W is the cross-sectional width.

For a two-layer film (see Figure 7), with each layer having the same cross-sectional width, but different thicknesses, the stress equation reads as follows:

$$\sigma_1 = F_1/d_1 W \text{ and } \sigma_2 = F_2/d_2 W$$

In order to balance the stress in the two layer material, the combined stress level of both layers must add to 0. Therefore:

Stress Total = $F_1 + F_2 = 0$ or
$\sigma_t = (\sigma_1 d_1 W + \sigma_2 d_2 W) = 0$
$\sigma_1 d_1 = \sigma_2 d_2$
$d_1/d_2 = -\sigma_2/\sigma_1$

Published values of typical stress levels of polysilicon and platinum silicide are:

$\sigma_1$ - 12 x $10^9$ dyne/cm$^2$ for PtSi
$\sigma_2$ = -5 x $10^9$ dyne/cm$^2$ for polysilicon
Then $d_1/d_2$ = 0.417

The formation of platinum silicide is known to have the requirement of about 1.3 nm of silicon for each nanometer of platinum, and will yield 1.97 nm of platinum silicide for each nanometer of platinum with a sufficient amount of polysilicon. For a balanced structure, this equates as follows:

$$P = FP + SP$$
$$d_1/d_2 = (1.97Pt)/(P + 1.3\ Pt)$$

Where P = polysilicon thickness, FP is the final polysilicon thickness after silicidation, SP is the thickness of the silicide of the polysilicon and the Pt is the platinum thickness.

By use of the above equations, the thickness of the platinum required for a certain thickness of polysilicon that will produce a stress free film by formation of platinum silicide can be readily calculated. The deposited stress levels of each film must be determined in order to enable the calculation of the proper film thickness and the stress level of the resulting combined structure.

## Claims

1. A method of producing a sensor comprising polycrystalline silicon low stress microstructures which are free-standing, and do not collapse due to internal compressive forces, utilising temperatures below 500°C, said method comprising the steps of
   - forming a layer of platinum on a layer of polycrystalline silicon which has a stress force in one direction to give a platinum-coated silicon layer and
   - sintering said platinum-coated silicon layer at a temperature of about 250°C to 400°C in an inert atmosphere for a period of about 45 to 60 minutes to convert a portion of the polycrystalline silicon into platinum silicide which has a stress force in the opposite direction, the stress level in the platinum silicide essentially cancelling out the stress level in the remaining unreacted portion of the polycrystalline silicon layer.

2. A method according to claim 1, wherein said polycrystalline silicon is formed by low pressure chemical vapor deposition of silicon tetrahydride.

3. A method according to claim 1, wherein said layer of platinum is formed by sputtering platinum onto said polycrystalline silicon layer.

## Patentansprüche

1. Verfahren zum Herstellen eines Sensors aus Mikrostrukturen aus polykristallinem Silizium niedriger Spannung, die freistehend sind und nicht aufgrund innerer Druckkräfte kollabieren, unter Verwendung von Temperaturen unterhalb 500°C, wobei dieses Verfahren die folgenden Schritte aufweist:
   - Bilden einer Platinschicht auf einer Schicht aus polykristallinem Silizium, das eine Spannungskraft in eine Richtung besitzt, um eine platinbeschichtete Siliziumschicht zu erzeugen, und
   - Sintern der platinbeschichteten Siliziumschicht bei einer Temperatur von ungefähr 250°C bis 400°C in einer inerten Atmosphäre während einer Dauer von ungefähr 45 bis 60 Minuten, um einen Teil des polykristallinen Siliziums in Platinsilizid umzuwandeln, das eine Spannungskraft in der entgegengesetzten Richtung besitzt, wobei die Spannung in dem Platinsilizid die Spannung in dem übrigen nicht reagierten Teil der Schicht aus polykristallinem Silizium aufhebt.

2. Verfahren nach Anspruch 1, bei dem das polykristalline Silizium durch eine chemische Niederdruck-Dampfabscheidung von Siliziumtetrahydrid gebildet wird.

3. Verfahren nach Anspruch 1, bei dem die Platinschicht durch Sputtern von Platin auf die Schicht aus polykristallinem Silizium gebildet wird.

**Revendications**

1. Procédé pour produire un capteur comprenant des microstructures autonomes à faibles contraintes en silicium polycristallin, qui ne s'effondrent pas en raison de forces de compression internes, par utilisation de températures inférieures à 500°C, procédé comprenant les étapes qui consistent :
   - à former une couche de platine sur une couche de silicium polycristallin présentant une force de contrainte dans une direction, pour donner une couche de silicium revêtue de platine, et
   - à fritter cette couche de silicium revêtue de platine à une température d'environ 250 à 400°C sous une atmosphère inerte pendant un laps de temps d'environ 45 à 60 minutes pour convertir une portion du silicium polycristallin en siliciure de platine, qui a une force de contrainte dans la direction opposée, le niveau de contrainte dans le siliciure de platine annulant presque complètement le niveau de contrainte dans la portion restante n'ayant pas réagi de la couche de silicium polycristallin.

2. Procédé selon la revendication 1, dans lequel le silicium polycristallin est formé par déposition chimique en phase vapeur, sous basse pression, de tétrahydrure de silicium.

3. Procédé selon la revendication 1, dans lequel la couche de platine est formée par pulvérisation cathodique de platine sur la couche de silicium polycristallin.

FIG 1

4

2

FIG 2

u. v.

8

6

4

2

FIG 3

10

4

2

FIG 4

12

4

2

FIG 5

12

4

2

FIG 6

FIG 7

FIG 8

FIG 9

FIG 10